# FASCICULE DE BREVET EUROPEEN

(11) **EP 2 777 075 B1**
(45) Date de publication et mention de la délivrance du brevet: **17.01.2018**
(21) Numéro de dépôt: 12795511.0
(22) Date de dépôt: 09.11.2012
(51) Int. Cl.: H01L 31/0216, H01L 31/0224, H01L 31/032, H01L 31/0392, H01L 31/18

(54) **SUBSTRAT CONDUCTEUR POUR CELLULE PHOTOVOLTAÏQUE**
LEITENDES SUBSTRAT FÜR PHOTOVOLTAISCHE ZELLE
CONDUCTING SUBSTRATE FOR PHOTOVOLTAIC CELL

(30) Priorité: 09.11.2011 FR 1160210
(43) Date de publication de la demande: 17.09.2014
(73) Titulaire: Saint-Gobain Glass France, 92400 Courbevoie (FR)
(72) Inventeur: PALM, Jörg, 80797 München (DE); URIEN, Mathieu, 94300 Vincennes (FR); RUITENBERG, Gérard, 52134 Herzogenrath (DE); LEYDER, Charles, 75019 Paris (FR); HEISS, Andreas, 82110 Germering (DE); MAHE, Erwan, 44700 Orvault (FR); DUPUY, Delphine, 91300 Massy (FR)
(74) Mandataire: Saint-Gobain Recherche
(86) Numéro de dépôt international: PCT/FR2012/052586
(87) Numéro de publication internationale: WO 2013/068702

(56) Documents cités:
- EP-A1- 2 668 666
- WO-A2-2008/095146
- FR-A1- 2 922 364
- US-A1- 2011 162 696

## Description

L'invention se rapporte au domaine des cellules photovoltaïques, plus particulièrement au domaine des substrats conducteurs à base de molybdène utilisés pour fabriquer des cellules photovoltaïques à couches minces.

En effet, de façon connue, certaines cellules photovoltaïques à couches minces, dites de seconde génération, utilisent un substrat conducteur à base de molybdène revêtu d'une couche d'agent absorbeur (i.e. matériau photoactif), généralement en chalcopyrite de cuivre Cu, d'indium In, et de sélénium Se et/ou de soufre S. II peut s'agir, par exemple, d'un matériau du type CuInSe₂. Ce type de matériau est connu sous l'abréviation CIS. II peut également s'agir de CIGS c'est-à-dire d'un matériau incorporant en outre du gallium, ou encore de matériaux du type Cu₂(Zn,Sn)(S,Se)₄ (i.e. CZTS), utilisant du zinc et/ou de l'étain plutôt que de l'indium et/ou du gallium.

Pour ce type d'application, les électrodes sont le plus souvent à base de molybdène (Mo) car ce matériau présente un certain nombre d'avantages. C'est un bon conducteur électrique (résistivité relativement faible de l'ordre de 10µΩ.cm). II peut être soumis aux traitements thermiques élevés nécessaires, car il a un point de fusion élevé (2610°C). II résiste, dans une certaine mesure, au sélénium et au soufre. Le dépôt de la couche d'agent absorbeur impose le plus souvent un contact avec une atmosphère contenant du sélénium ou du soufre qui tend à détériorer la plupart des métaux. Le molybdène réagit avec le sélénium ou le soufre notamment, formant du MoSe₂, MoS₂ ou Mo(S,Se)₂, mais garde l'essentiel de ses propriétés, notamment électriques, et conserve un contact électrique adéquat avec par exemple la couche de CIS, de CIGS, ou de CZTS. Enfin, c'est un matériau sur lequel les couches de type CIS, CIGS ou CZTS adhèrent bien, le molybdène tend même à en favoriser la croissance cristalline.

Cependant, le molybdène présente un inconvénient important quand on envisage une production industrielle : c'est un matériau coûteux. En effet, les couches en molybdène sont habituellement déposées par pulvérisation cathodique (assistée par champ magnétique). Or les cibles de molybdène sont onéreuses. Cela est d'autant moins négligeable que pour obtenir le niveau de conductivité électrique voulu (une résistance par carré inférieure ou égale à 20/□, et de préférence inférieure ou égale à 1 ou même 0,5Ω/□ après traitement dans une atmosphère contenant du S ou du Se), il faut une couche de Mo relativement épaisse, généralement de l'ordre de 400 nm à 1 micromètre.

La demande de brevet WO-A-02/065554 de SAINT-GOBAIN GLASS FRANCE enseigne de prévoir une couche relativement mince de molybdène (inférieure à 500nm) et de prévoir une ou plusieurs couches imperméables aux alcalins entre le substrat et la couche à base de molybdène, de façon à préserver les qualités de la fine couche à base de molybdène lors des traitements thermiques subséquents.

Ce type de substrat conducteur reste néanmoins relativement coûteux.

Un but de la présente invention est de fournir un nouveau substrat conducteur à base de molybdène dont le coût de fabrication soit relativement faible.

A cet effet, la présente invention a notamment pour objet un substrat conducteur pour cellule photovoltaïque, comprenant un substrat porteur et un revêtement électrode formé sur le substrat porteur, dans lequel le revêtement électrode comprend :
- une couche principale à base de molybdène formée sur le substrat porteur ;
- une couche barrière à la sélénisation formée sur la couche principale à base de molybdène, la couche barrière à la sélénisation ayant une épaisseur inférieure à 50nm, de préférence inférieure ou égale à 30nm, de préférence encore inférieure ou égale à 20nm ; et
- sur la couche barrière à la sélénisation, une couche supérieure à base d'un métal M propre à former, après sulfuration et/ou sélénisation, une couche de contact ohmique avec un matériau semi-conducteur photoactif.

Un tel substrat conducteur présente l'avantage de permettre d'obtenir, avec des épaisseurs moindres de molybdène, une résistance par carré équivalente à celle d'un substrat conducteur dont le revêtement électrode est constitué d'une seule couche de molybdène.

Grâce au substrat conducteur, le procédé de fabrication de la cellule photovoltaïque (ou module photovoltaïque) est en outre particulièrement fiable. La couche barrière à la sélénisation permet en effet à la fois de garantir la présence et la quantité de Mo(S,Se)₂ par la transformation de l'intégralité de la couche supérieure (par exemple si son épaisseur est entre 10 et 50nm) tout en garantissant la présence et une épaisseur uniforme d'une couche principale à base de molybdène dont les propriétés de conductance ont été préservées. La préservation des qualités de la couche principale à base de molybdène et l'uniformité de son épaisseur permettent de réduire les quantités de matériaux au plus juste.

L'uniformité de la couche de contact ohmique formée par la couche supérieure après sélénisation et/ou sulfuration bénéficie en outre à l'efficacité de la cellule solaire.

WO-A-2005/088731 décrit une amélioration du coefficient de réflexion du substrat conducteur avec une couche de TiN ou de ZrN. Néanmoins, les couches d'absorbeur testées pour la présente invention étaient trop épaisses pour que cet effet puisse avoir une influence sur les performances. Qui plus est, les couches de TiON testées ici étaient également trop fines pour augmenter le coefficient de réflexion de manière significative. WO 2008/095146 A2 divulgue un substrat conducteur pour cellule photovoltaïque comprenant une couche inter-faciale sur la couche électrode. Suivant des modes particuliers de réalisation, le substrat conducteur comporte l'une ou plusieurs des caractéristiques suivantes, prise(s) isolément ou suivant toutes les combinaisons techniquement possibles :
- la couche barrière à la sélénisation est à base d'un nitrure ou d'un oxynitrure métallique avec le métal M choisi parmi le titane, le molybdène, le zirconium ou le tantale et une teneur en oxygène x=O/(O+N) avec x= 0 ou 0<x<1 ;
- la couche barrière à la sélénisation est à base d'un oxynitrure métallique avec le métal M choisi parmi le titane, le molybdène, le zirconium ou le tantale et une teneur en oxygène x=O/(O+N) avec 0<x<1, par exemple 0,05<x<0,95, par exemple 0,1<x<0,9 ;
- la couche barrière à la sélénisation a une résistivité comprise entre 200µOhm.cm et 500µOhm.cm ;
- la couche barrière à la sélénisation est un composé à base de molybdène avec une teneur élevée en oxygène et/ou en azote ;
- la couche barrière à la sélénisation a une résistivité comprise entre 20µOhm.cm et 50µOhm.cm ;
- ledit métal M est propre à former un composé de type sulfure et/ou séléniure semi-conducteur de type p avec une concentration de porteurs de charge supérieure ou égale à 10¹⁶/cm³ et un travail de sortie supérieur ou égal à 4,5eV ;
- ladite couche supérieure à base d'un métal M est à base de molybdène et/ou de tungstène ;
- ladite couche supérieure à base d'un métal M a une épaisseur supérieure ou égale à 10nm, de préférence supérieure ou égale à 20nm et inférieure ou inférieure ou égale à 100nm, de préférence inférieure ou égale à 50nm ;
- la couche barrière à la sélénisation a une épaisseur supérieure ou égale à 3nm, de préférence supérieure ou égale à 5nm ;
- la couche principale à base de molybdène a une épaisseur inférieure ou égale à 400nm, par exemple inférieure ou égale à 300nm, par exemple inférieure ou égale à 250nm ;
- la couche principale à base de molybdène a une épaisseur supérieure ou égale à 40nm, de préférence supérieure ou égale à 150nm ;
- la couche principale à base de molybdène a une épaisseur uniforme, l'épaisseur restant de préférence dans un intervalle de +/-10% par rapport à une valeur moyenne ;
- le revêtement électrode a une résistance par carré inférieure ou égale à 2Ω/□, de préférence inférieure ou égale à 1Ω/□ ;
- ladite couche supérieure à base d'un métal M est formée directement sur la couche barrière à la sélénisation ;
- la couche barrière à la sélénisation est formée directement sur.la couche principale à base de molybdène ;
- le substrat porteur est dans un matériau contenant des alcalins, le substrat conducteur comprenant une ou plus couches barrières aux alcalins formées sur le substrat porteur et sous la couche principale à base de molybdène, la ou les couches barrières aux alcalins étant par exemple à base de l'un des matériaux choisis parmi : le nitrure, l'oxyde, l'oxynitrure ou l'oxycarbure de silicium, l'oxyde ou l'oxynitrure d'aluminium ;
- le substrat porteur est une feuille de verre.

L'invention a également pour objet un dispositif semi-conducteur comprenant un substrat porteur et un revêtement électrode formé sur le substrat porteur, le revêtement électrode comprenant :
- une couche principale à base de molybdène ;
- une couche barrière à la sélénisation formée sur la couche principale à base de molybdène, la couche barrière à la sélénisation ayant une épaisseure inférieure à 50 nm;
- une couche photoactive en un matériau semi-conducteur photoactif à base de chalcopyrite de cuivre et de sélénium et/ou de soufre, par exemple un matériau de type Cu(In,Ga)(S,Se)₂, notamment CIS ou CIGS, ou encore un matériau de type Cu₂(Zn,Sn)(S,Se)₄, la couche photoactive étant formée sur la couche barrière à la sélénisation ; et
- entre la couche barrière à la sélénisation et la couche photoactive, une couche de contact ohmique à base d'un composé de type sulfure et/ou séléniure d'un métal M.

Suivant des modes particuliers de réalisation, le dispositif semi-conducteur comporte l'une ou plusieurs des caractéristiques suivantes, prise(s) isolément ou suivant toutes les combinaisons techniquement possibles :
- le matériau de la couche de contact ohmique est un matériau semi-conducteur de type p avec une concentration de porteurs de charge supérieure ou égale à 10¹⁶/cm³ et un travail de sortie supérieur ou égal à 4,5eV ;
- la couche de contact ohmique est à base d'un composé de type sulfure et/ou séléniure de molybdène et/ou de tungstène.

L'invention a encore pour objet une cellule photovoltaïque comprenant un dispositif semi-conducteur tel que décrit ci-dessus, et un revêtement électrode transparent formé sur la couche photoactive.

Un autre objet de l'invention est un module photovoltaïque comprenant une pluralité de cellules photovoltaïques reliées entre elles en série et toutes formées sur le même substrat, dans lequel les cellules photovoltaïques sont telles que décrites ci-dessus.

L'invention a également pour objet un procédé de fabrication d'un substrat conducteur pour cellule photovoltaïque, comprenant des étapes consistant à :
- déposer une couche principale à base de molybdène sur un substrat porteur;
- déposer une couche barrière à la sélénisation sur la couche principale à base de molybdène, la couche barrière à la sélénisation ayant une épaisseur inférieure à 50 nm;
- déposer, sur la couche barrière à la sélénisation, une couche supérieure à base d'un métal M propre à former, après sulfuration et/ou sélénisation, une couche de contact ohmique avec un matériau semi-conducteur photoactif ; et
- transformer la couche supérieure à base de métal M en un sulfure et/ou séléniure du métal M.

Suivant des modes particuliers de réalisation, le procédé présente l'une ou plusieurs des caractéristiques suivantes, prise(s) isolément ou suivant toutes les combinaisons techniquement possibles :
- le procédé comprend une étape de formation d'une couche photoactive par sélénisation et/ou sulfuration, sur ladite couche supérieure à base d'un métal M, l'étape de transformation de ladite couche supérieure à base d'un métal M étant réalisée avant ou pendant la formation de ladite couche photoactive, de préférence pendant ;
- après sulfuration et/ou sélénisation, ladite couche supérieure est à base d'un semi-conducteur de type p avec une concentration de porteurs de charge supérieure ou égale à 10¹⁶/cm³ et un travail de sortie supérieur ou égal à 4,5eV ;
- après sulfuration et/ou sélénisation, ladite couche supérieure est un composé à base de sulfure et/ou séléniure de molybdène et/ou de tungstène ;
- l'étape de formation de la couche photoactive comprenant une étape de sélénisation et/ou sulfuration à une température supérieure ou égale à 300°C.

L'invention sera mieux comprise à la lecture de la description qui va suivre, donnée uniquement à titre d'exemple, et faite en référence aux dessins annexés, sur lesquels :
- la figure 1 est une vue schématique en coupe d'un substrat conducteur ;
- la figure 2 est une vue schématique en coupe d'une cellule photovoltaïque comprenant un substrat conducteur selon la figure 1 ;
- les figures 3a et 3b sont des vues en coupe obtenues par microscopie électronique, la figure 3b représentant un dispositif semi-conducteur après traitement à haute température et haute pression partielle en sélénium et dont le substrat conducteur ne possédait à l'origine qu'une seule couche de molybdène tandis qu'il possédait en outre sur la figure 3a une couche barrière à la sélénisation, à base de TiON, et une couche supérieure de contact ohmique, à base de Mo ;

- la figure 4 est une image en coupe par microscopie électronique de la section d'un substrat conducteur amélioré;
- la figure 5 est une image analogue à celle de la figure 4 d'un dispositif semi-conducteur dans lequel une couche mince CIGSSe a été formée par sélénisation sur le substrat conducteur de la figure 4 ;
- les figures 6 et 7 illustrent l'efficacité de cellules utilisant des substrats conducteurs Si₃N₄ (140nm) / Mo avec différentes épaisseurs de Mo avec et sans couche barrière à la sélénisation ; et
- la figure 8 montre des résultats expérimentaux de tests de sélénisation tel que décrits ci-dessous.

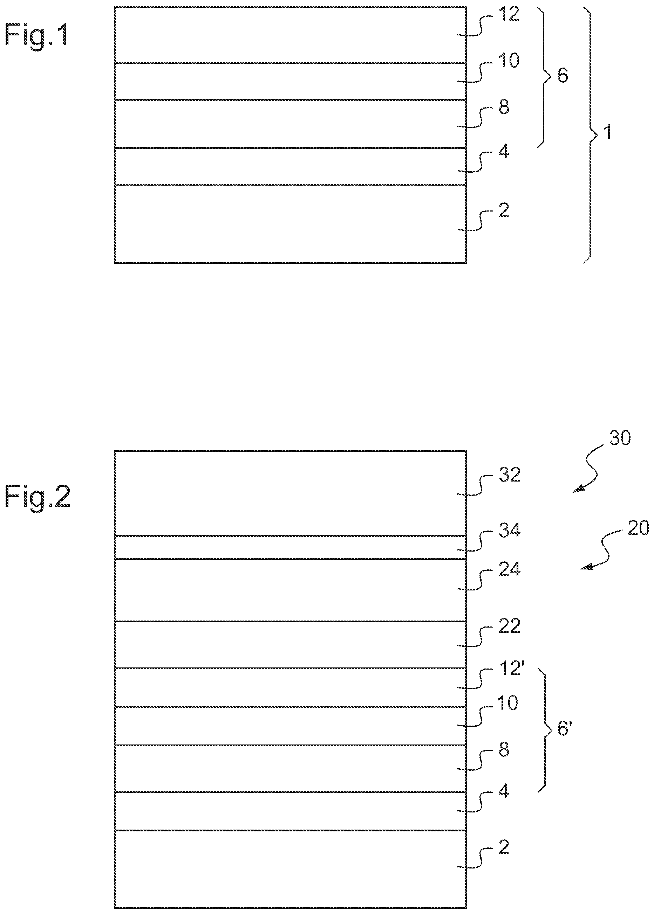

Les dessins des figures 1 à 2 ne sont pas à l'échelle, pour une représentation claire, car les différences d'épaisseur entre notamment le substrat porteur et les couches déposées sont importantes, par exemple de l'ordre d'un facteur 500.

Sur la figure 1 est illustré un substrat conducteur 1 pour cellule photovoltaïque comprenant :
- un substrat porteur 2 en verre ;
- une couche barrière aux alcalins 4 formée sur le substrat 2 ; et
- un revêtement électrode 6 à base de molybdène formé sur la couche barrière aux alcalins 4.

On entend, dans tout le texte, par « une couche A formée (ou déposée) sur une couche B », une couche A formée soit directement sur la couche B et donc en contact avec la couche B, soit formée sur la couche B avec interposition d'une ou plusieurs couches entre la couche A et la couche B.

A noter qu'on entend dans tout le texte par « revêtement électrode », un revêtement d'amenée de courant comprenant au moins une couche électroniquement conductrice, c'est-à-dire dont la conductivité est assurée par la mobilité des électrons.

En outre, dans tout le texte, « comprend une couche » doit bien entendu s'entendre comme « comprend au moins une couche ».

Le revêtement électrode 6 illustré est constitué :
- d'une couche principale 8 à base de molybdène formée directement sur la couche barrière aux alcalins 4 ;
- d'une couche barrière à la sélénisation 10 formée directement sur la couche principale 8 à base de molybdène et de faible épaisseur ; et
- d'une couche supérieure 12 à base d'un métal M, formée directement sur la couche barrière à la sélénisation 10.

Un tel substrat conducteur 1 est destiné à la fabrication d'un matériau photoactif avec adjonction de sodium (il est connu que le sodium améliore les performances des matériaux photoactifs de type CIS ou CIGS). La couche barrière aux alcalins 4 empêche la migration des ions sodium depuis le substrat 2 en verre, pour un meilleur contrôle de l'adjonction de sodium dans le matériau photoactif.

Dans le cas où le substrat ne contient pas d'ions alcalins, la couche barrière aux alcalins 4 peut être omise.

Une autre technique de fabrication du matériau photoactif consiste à utiliser la migration des ions sodium depuis le substrat porteur en verre pour former le matériau photoactif. Dans ce cas, le substrat conducteur 1 ne possède pas de couche barrière aux alcalins 4 et la couche principale 8 de molybdène est par exemple formée directement sur le substrat porteur 2.

En variante également, le revêtement électrode 6 comprend une ou plusieurs couches intercalaires.

Ainsi, d'une manière générale, le substrat conducteur 1 comprend un substrat porteur 2 et un revêtement électrode 6 comprenant :
- une couche principale 8 à base de molybdène formée sur le substrat porteur 2 ;
- une couche barrière à la sélénisation 10 formée sur la couche principale 8 à base de molybdène ; et
- une couche supérieure 12 à base d'un métal M formée sur la couche barrière à la sélénisation 10.

Le métal M est propre à former, après sulfuration et/ou sélénisation, une couche de contact ohmique avec un matériau semi-conducteur photoactif, notamment avec un matériau semi-conducteur photoactif à base de chalcopyrite de cuivre et de sélénium et/ou de soufre par exemple un matériau photoactif de type Cu(In,Ga)(S,Se)₂, notamment CIS ou CIGS, ou encore un matériau de type Cu₂(Zn,Sn)(S,Se)₄.

On entend par une couche de contact ohmique une couche d'un matériau tel que la caractéristique courant / tension du contact est non-rectifiante et linéaire.

De préférence, la couche supérieure 12 est la dernière couche supérieure du revêtement électrode 6, c'est-à-dire que le revêtement électrode 6 ne possède pas une autre couche au-dessus de la couche 12.

De préférence également, le revêtement électrode 6 comprend une seule couche principale 8 à base de molybdène, une seule couche barrière à la sélénisation 10, et une seule couche 12.

II est à noter qu'on entend, dans tout le texte, par « une seule couche », une couche d'un même matériau. Cette unique couche peut néanmoins être obtenue par la superposition de plusieurs couches d'un même matériau, entre lesquelles existe une interface qu'il est possible de caractériser, comme décrit dans WO-A-2009/080931.

Typiquement, dans une enceinte de dépôt magnétron, plusieurs couches d'un même matériau seront formées successivement sur le substrat porteur par plusieurs cibles pour former au final une seule couche du même matériau, à savoir le molybdène.

A noter qu'on entend par le terme « à base de molybdène », un matériau composé d'une quantité substantielle de molybdène, c'est-à-dire soit un matériau constitué seulement de molybdène, soit un alliage comprenant majoritairement du molybdène, soit un composé comprenant majoritairement du molybdène mais avec une teneur en oxygène et/ou en azote, par exemple une teneur conduisant à une résistivité supérieure ou égale à 20µOhm.cm.

La couche 12 est destinée à être intégralement transformée par sélénisation et/ou sulfuration en Mo(S,Se)₂, lequel matériau n'est en revanche pas considéré comme un matériau « à base de molybdène » mais un matériau à base de disulfure de molybdène, de diséléniure de molybdène ou d'un mélange de disulfure et de diséléniure de molybdène.

De manière conventionnelle, la notation (S,Se) indique qu'il s'agit d'une combinaison de SₓSe₁₋ₓ avec 0≤*x*≤1.

II est important de noter que le substrat illustré sur la figure 1 et décrit ci-dessus est un produit intermédiaire dans la fabrication d'un module photovoltaïque. Ce produit intermédiaire est ensuite transformé du fait du procédé de fabrication du matériau photoactif. Le substrat conducteur 1 décrit ci-dessus s'entend comme le produit intermédiaire avant transformation, lequel peut être stocké et acheminé vers d'autres sites de production pour la fabrication du module.

La couche supérieure 12, de façon à jouer son rôle de contact ohmique une fois transformée en Mo(S,Se)₂, a par exemple une épaisseur supérieure ou égale à 10nm, et inférieure ou égale à 100nm, de préférence comprise entre 30nm et 50nm. Une épaisseur importante n'est pas nécessaire.

Ledit métal M est avantageusement à base de molybdène et/ou de tungstène.

Les composés de disulfure et/ou de diséléniure de molybdène Mo(S,Se)₂ sont des matériaux dont l'efficacité comme couche de contact ohmique est prouvée. Le tungstène (W) est un matériau aux propriétés chimiques analogues. II forme également des semi-conducteurs chalcogénides WS₂ et WSe₂. Mo(S,Se)₂ et W(S,Se)₂ peuvent tous deux être formés comme des semi-conducteurs de type p avec un dopage de type p supérieur ou égal à 10¹⁶/cm³ et un travail de sortie d'environ 5ev. D'une manière générale, il peut s'agir d'un matériau à base d'un métal M propre à former un composé de type sulfure et/ou séléniure semi-conducteur de type p avec une concentration de porteurs de charge supérieure ou égale à 10¹⁶/cm³ et un travail de sortie supérieur ou égal à 4,5eV. Plus généralement encore, il s'agit d'un métal M de tout type apte à former, après sulfuration et/ou sélénisation, une couche de contact ohmique avec un matériau semi-conducteur photoactif, plus particulièrement avec un matériau photoactif à base de chalcopyrite de cuivre et de sélénium et/ou de soufre.

La couche barrière à la sélénisation 10 protège la couche principale 8 à base de molybdène d'une sélénisation et/ou sulfuration éventuelle. A noter qu'une couche protégeant de la sélénisation protège également de la sulfuration.

On entend par couche barrière à la sélénisation, une couche d'un matériau de tout type adapté pour empêcher ou réduire la sélénisation des couches couvertes par la couche barrière à la sélénisation lors du dépôt, sur la couche barrière à la sélénisation, de couches de matériaux semi-conducteurs formés par sélénisation et/ou sulfuration. La couche barrière à la sélénisation au sens de l'invention montre une efficacité prouvée même à une épaisseur de 3nm.

Un test possible pour savoir si un matériau est adapté ou non pour un rôle de barrière à la sélénisation est de comparer un échantillon avec et sans une couche de 5nm de ce matériau entre la couche supérieure 12 à base d'un métal M et la couche principale 8 et de faire subir une sélénisation aux échantillons, par exemple par chauffage à 520°C dans une atmosphère à 100% de sélénium. Si la sélénisation de la couche principale 8 est réduite ou empêchée et la couche supérieure 12 entièrement sélénisée, le matériau est efficace.

Le matériau de la couche barrière à la sélénisation 10 est par exemple à base d'un nitrure de métal tel que le nitrure de titane, le nitrure de molybdène, le nitrure de zirconium ou le nitrure de tantale, ou une combinaison de ces matériaux. II peut également s'agir d'un oxynitrure.

D'une manière générale, il s'agit d'un matériau de tout type adapté pour protéger la couche principale 8 à base de molybdène d'une sélénisation ou sulfuration éventuelle.

II peut également être à base d'un oxyde métallique tel que l'oxyde de molybdène, l'oxyde de titane ou un oxyde mixte de molybdène et de titane.

Les nitrures sont cependant préférés aux oxydes.

De façon préférée encore, il s'agit d'un matériau à base d'un oxynitrure métallique avec M choisi parmi le titane, le molybdène, le zirconium ou le tantale, et avec un teneur en oxygène x= O/(O+N) avec 0<x<1, par exemple 0,05<x<0,95, par exemple 0,1<x<0,9.

II est à noter que les nitrures, oxydes et oxynitrures ci-dessus peuvent être sous-stoechiométriques, stoechiométriques ou sur-stoechiométriques respectivement en azote et en oxygène.

En variante, il s'agit d'une couche à base de molybdène, plus précisément d'un composé à base de molybdène avec une teneur élevée en oxygène et/ou en azote. La teneur en oxygène et/ou en azote est par exemple suffisante si elle induit une résistivité supérieure ou égale à 20µOhm.cm.

D'une manière générale, il s'agit donc d'une couche à base de molybdène avec une teneur élevée en oxygène et/ou en azote ou d'un matériau à base d'un nitrure, d'un oxyde ou d'un oxynitrure métallique adapté pour protéger la couche principale 8 à base de molybdène d'une sélénisation ou sulfuration éventuelle.

La couche barrière à la sélénisation 10 est de faible épaisseur. Elle a une épaisseur inférieure à 50nm, de préférence inférieure ou égale à 30nm, de préférence encore inférieure ou égale à 15nm.

Si la couche barrière à la sélénisation 10 est très fine, elle risque de ne plus avoir une influence significative. Elle a ainsi par exemple une épaisseur supérieure ou égale à 3nm, de préférence supérieure ou égale à 5nm. De façon surprenante, il s'est en effet avéré qu'une couche barrière à la sélénisation 10 d'une si faible épaisseur avait un effet significatif.

La couche barrière à la sélénisation 10 a une conductivité moindre que la couche principale 8 à base de molybdène. Elle a par exemple une résistivité comprise entre 200µOhm.cm et 500µOhm.cm dans le cas d'une couche à base d'une oxyde, nitrure ou oxynitrure métallique et une résistivité comprise entre 20µOhm.cm et 50µOhm.cm dans le cas d'un matériau à base de molybdène avec une teneur élevée en azote et/ou en oxygène.

Du fait de la faible épaisseur de la couche barrière à la sélénisation 10, une résistivité élevée ne nuit pas aux performances de la cellule, le courant électrique passant transversalement.

La couche barrière à la sélénisation 10 est en outre de préférence apte à limiter la diffusion arrière des ions sodium vers le substrat porteur 2, c'est-à-dire la diffusion des ions sodium depuis le dessus de la couche supérieure 12, à travers la couche supérieure 12 et vers le substrat porteur 2.

Cette propriété est avantageuse à plusieurs égards.

Elle fiabilise les procédé de fabrication consistant à ajouter des alcalins pour former le matériau photoactif, par exemple par dépôt de diséléniure de sodium sur la couche supérieure 12 du revêtement électrode 6 ou par adjonction de sodium pendant le dépôt du matériau photoactif, par exemple en utilisant des cibles contenant du sodium ou autres alcalins, comme décrit dans US-B-5 626 688.

La couche principale à base de molybdène 8 a une épaisseur suffisante pour que le revêtement électrode 6 ait, après un test de sélénisation tel que décrit ci-dessus, une résistance par carré inférieure ou égale à 2Ω/□, de préférence inférieure ou égale à 1Ω/□. La présence de la couche supérieure 12 à base du métal M et de la couche barrière à la sélénisation 10 permet d'atteindre de telles performances.

Dans l'hypothèse d'un revêtement électrode 6 ne comprenant pas d'autres couches électroconductrices que la couche principale 8 à base de molybdène, la couche barrière à la sélénisation 10 et la couche supérieure 12 à base du métal M, la couche principale à base de molybdène 8, pour avoir un effet significatif, a de préférence une épaisseur supérieure ou égale à 40nm, de préférence supérieure ou égale à 150nm. Toutefois, la couche principale à base de molybdène 8 a par exemple une épaisseur inférieure ou égale à 400nm, par exemple inférieure ou égale à 300nm, par exemple inférieure ou égale à 250nm.

Diminuer l'épaisseur de la couche principale à base de molybdène 8 présente un avantage: permettre de déposer cette couche relativement fine par pulvérisation cathodique avec des paramètres de dépôt conduisant à une couche fortement contrainte, sans les problèmes de délamination que l'on peut rencontrer avec des couches épaisses.

La couche principale à base de molybdène 8 est par exemple constituée de molybdène, c'est-à-dire qu'elle comprend seulement du molybdène.

Le substrat porteur 2 et la couche barrière aux alcalins 4 vont maintenant être décrits.

Deux cas sont à distinguer. Le cas où une migration d'ions alcalins depuis le substrat est souhaitée pour doper la couche de matériau photoactif et le cas où cette migration n'est pas souhaitée.

Les substrats pourvus d'une ou plusieurs couches barrières aux alcalins 4 sont utilisés dans le deuxième cas notamment pour permettre d'utiliser comme substrat une feuille de verre de type silico-sodo-calcique obtenue par flottage, verre d'un coût relativement faible et qui présente toutes les qualités que l'on connait à ce type de matériau, comme par exemple sa transparence, son imperméabilité à l'eau et sa dureté.

La teneur en ions alcalins du substrat 2 est dans ce cas un inconvénient que la couche barrière aux alcalins vient minimiser.

La couche barrière aux alcalins 4 est par exemple à base de l'un des matériaux choisis parmi : le nitrure, l'oxyde, l'oxynitrure ou l'oxycarbure de silicium, l'oxyde ou l'oxynitrure d'aluminium.

En variante, toujours dans le deuxième cas, le substrat porteur 2 est une feuille d'un matériau de tout type adapté, par exemple un verre à base de silice ne contenant pas d'alcalins, tels que les verres borosilicatés, ou en matière plastique, ou même en métal.

Dans le premier cas, le substrat porteur 2 est de tout type adapté et contient des alcalins, par exemple des ions sodium et potassium. Le substrat est par exemple un verre silico-sodo-calcique. La couche barrière aux alcalins est absente.

Dans les deux cas, le substrat porteur 2 est destiné à servir de contact arrière dans le module photovoltaïque et ne nécessite pas d'être transparent.

La feuille constituant le substrat porteur 2 peut être plane ou bombée, et présenter tout type de dimensions, notamment au moins une dimension supérieure à 1 mètre.

L'invention a également pour objet un procédé de fabrication du substrat conducteur 1 décrit ci-dessus.

Le procédé comprend des étapes consistant à :
- déposer la couche principale 8 base de molybdène sur le substrat porteur 2 , avec dépôt éventuel préalable de la couche barrière aux alcalins 4;
- déposer la couche barrière à la sélénisation 10 sur la couche principale 8 à base de molybdène, par exemple directement dessus ;
- déposer la couche supérieure 12 à base du métal M sur la couche barrière à la sélénisation 10 ; et
- transformer ladite couche à base de métal M en un sulfure et/ou séléniure du métal M. Cette étape de transformation peut être une étape séparée avant la formation la couche semi-conductrice CIS, CGS ou CZTS ou une étape réalisée pendant la sélénisation et/ou sulfuration de la couche semi-conductrice CIS, CGS ou CZTS, que cette sélénisation et/ou sulfuration soit réalisée pendant le dépôt de ladite couche semi-conductrice ou après le dépôt de composants métalliques dits précurseurs de la couche semi-conductrice.

Le dépôt des différentes couches est par exemple réalisé par pulvérisation cathodique assistée par magnétron mais il s'agit en variante d'un autre procédé de tout type adapté.

L'invention a également pour objet un dispositif semi-conducteur 20 (figure 2) utilisant le substrat conducteur 1 décrit ci-dessus pour y former une ou plusieurs couches photoactives 22, 24.

La première couche photoactive 22 est typiquement une couche dopée de type p, par exemple à base de chalcopyrite de cuivre Cu, d'indium In, et de sélénium Se et/ou de soufre S. II peut s'agir, par exemple, comme expliqué précédemment, de CIS, CIGS ou CZTS.

La deuxième couche photoactive 24 est dopée de type n et dite tampon. Elle est par exemple composée de CdS (sulfure de cadmium) et formée directement sur la première couche photoactive 22.

En variante, la couche tampon 24 est par exemple à base de InₓS_{y}, Zn(O,S), ou ZnMgO ou dans un autre matériau de tout type adapté. En variante également, la cellule ne comprend pas de couche tampon, la première couche photoactive 22 pouvant elle-même former une homojonction p-n.

D'une manière générale, la première couche photoactive 22 est une couche de type p ou à homojonction p-n obtenue par addition d'éléments alcalins.

Le dépôt de la couche photoactive comprend des étapes de sélénisation et/ou de sulfuration, comme expliqué plus en détail ci-dessous. Le dépôt peut être réalisé par évaporation des éléments Cu, In, Ga et Se (ou Cu, Sn, Zn, S). Lors de ces étapes de sélénisation et/ou de sulfuration, la couche supérieure 12 à base du métal M est transformée en une couche 12' à base de M(S,Se)₂. Cette transformation concerne par exemple l'intégralité de la couche supérieure 12.

Le dispositif semi-conducteur 20 comprend donc :
- le substrat porteur 2 et le revêtement électrode 6' formé sur le substrat porteur 2 et dont la couche supérieure 12' a été transformée.

Le revêtement électrode 6' comprend :
- la couche principale 8 à base de molybdène ;
- la couche barrière à la sélénisation 10 formée sur la couche principale à base de molybdène 8 ; et
- la couche supérieure 12' de contact ohmique, à base de M(S,Se)₂, formée sur la couche barrière à la sélénisation 10. Sur la couche de contact ohmique 12' et en contact avec celle-ci, le dispositif semi-conducteur comprend la ou les couches semi-conductrices photoactives 14, 16.

L'invention a également pour objet une cellule photovoltaïque 30 comprenant un dispositif semi-conducteur 20 tel que décrit ci-dessus.

La cellule comprend par exemple, comme illustré sur la figure 2 :
- le dispositif semi-conducteur 20 formé par les couches 8, 10, 12', 22 et 24 ;
- un revêtement électrode transparent 32, par exemple en ZnO :Al, formé sur la première couche photoactive 22, et sur la couche tampon 24 en cas de présence de cette dernière, avec interposition éventuelle entre le revêtement électrode transparent 32 et le dispositif semi-conducteur 20 d'une couche passivante 34, par exemple de ZnO intrinsèque ou de ZnMgO intrinsèque.

Le revêtement électrode transparent 32 comprend en variante une couche d'oxyde de zinc dopée avec du gallium, ou du bore, ou encore une couche d'ITO.

D'une manière générale, il s'agit d'un matériau conducteur transparent (TCO) de tout type adapté.

Pour une bonne connexion électrique et une bonne conductance, une grille métallique (non représentée sur la figure 2) est ensuite optionnellement déposée sur le revêtement électrode transparent 32, par exemple à travers un masque, par exemple par faisceau d'électrons. II s'agit par exemple d'une grille de Al (aluminium) par exemple d'environ 2µm d'épaisseur sur laquelle est déposée une grille de Ni (nickel) par exemple d'environ 50nm d'épaisseur pour protéger la couche de Al.

La cellule 30 est ensuite protégée des agressions extérieures. Elle comprend par exemple à cet effet un contre-substrat (non représenté) couvrant le revêtement électrode avant 32 et feuilleté au substrat porteur 2 par l'intermédiaire d'un intercalaire de feuilletage (non représenté) en matière thermoplastique. II s'agit par exemple d'une feuille en EVA, PU ou PVB.

L'invention a également pour objet un module photovoltaïque comprenant plusieurs cellules photovoltaïques formées sur le même substrat 2, reliées en série entre elles et obtenues par margeage des couches du dispositif semi-conducteur 20.

L'invention a encore pour objet un procédé de fabrication du dispositif semi-conducteur 20 et de la cellule photovoltaïque 30 ci-dessus, lequel procédé comprend une étape de formation d'une couche photoactive par sélénisation et/ou sulfuration.

II existe de nombreux procédés connus de fabrication d'une couche photoactive de type Cu(In,Ga)(S,Se)₂. La couche photoactive 22 est par exemple une couche de CIGS formée de la façon suivante.

Dans une première étape, les précurseurs de la couche sont déposés sur le revêtement électrode 6.

Un empilement métallique composé d'une alternance de couches de type CuGa et In est par exemple déposé par pulvérisation cathodique magnétron à température ambiante, sur le revêtement électrode 6. Une couche de sélénium est ensuite déposée à température ambiante directement sur l'empilement métallique, par exemple par évaporation thermique.

En variante, l'empilement métallique a par exemple une structure multicouches de type Cu/In/Ga/Cu/In/Ga.....

Dans une deuxième étape, le substrat subit un traitement de chauffage à haute température dit RTP (« Rapid Thermal Process, RTP » en anglais), par exemple à environ 520°C dans une atmosphère composée par exemple de soufre gazeux, par exemple à base de S ou de H₂S, formant ainsi une couche de CuInₓGa₁₋ₓ(S,Se)₂.

Un avantage de ce procédé est qu'il ne nécessite pas une source externe de vapeur de sélénium. La perte d'une partie du sélénium pendant le chauffage est compensé par un dépôt en excès de sélénium sur l'empilement métallique. Le sélénium nécessaire à la sélénisation est fourni par la couche de sélénium déposée.

En variante, la sélénisation est obtenue sans le dépôt d'une couche de sélénium mais par une atmosphère contenant du sélénium gazeux, par exemple à base de Se ou de H₂Se, préalablement à l'exposition à une atmosphère riche en soufre.

L'étape de sulfuration permet de s'abstenir éventuellement d'une couche tampon par exemple de CdS.

Comme expliqué ci-dessus, il peut être avantageux de procéder à un dépôt d'une couche à base d'alcalins, par exemple de sodium, pour un dosage précis du sodium dans la couche photoactive.

Préalablement au dépôt de l'empilement métallique CuGa et In, les alcalins sont par exemple introduits par le dépôt, sur la couche sacrificielle 12 à base de molybdène, d'une couche de séléniure de sodium ou d'un composé contenant du sodium de façon à introduire par exemple de l'ordre de 2.10¹⁵ atomes de sodium par cm². L'empilement métallique est déposé directement sur cette couche de séléniure de sodium.

A noter qu'il existe de nombreuses variantes possibles pour former les couches de CI(G)S ou CZTS, lesquelles incluent par exemple la coévaporation des éléments mentionnée plus haut, le dépôt par vapeur chimique, le dépôt électrochimique de métaux, séléniures ou chalcopyrites, la pulvérisation réactive de métaux ou séléniures en présence de H₂Se ou H₂S.

D'une manière générale, le procédé de fabrication de la couche photoactive 22 est de tout type adapté.

Tous les procédés de fabrication de couches de type CIS ou CZTS utilisent une étape de chauffage à haute température en présence de sélénium et/ou de soufre à l'état de vapeur ou à l'état liquide.

### EXEMPLES ET RESULTATS

Les performances de cellules photovoltaïques incorporant différents revêtements électrodes à base de molybdène ont été testées avec succès.

Dans tous les exemples, un substrat porteur 2 en verre silico-sodo-calcique d'une épaisseur de 3mm a été utilisé, avec une couche barrière aux alcalins constituée de Si₃N₄ et d'une épaisseur de 140nm déposée directement sur le substrat porteur 2 en verre.

Les cellules photovoltaïques ont été produites par formation de Cu(In,Ga)(S,Se)₂ en deux étapes. Un empilement précurseur contenant Cu, Ga, In et Na a été déposé par pulvérisation magnétron de la façon décrite ci-dessus.

Une couche de sélénium a ensuite été déposée par évaporation thermique.

L'empilement précurseur a ensuite été transformé en Cu(In,Ga)(S,Se)₂ par procédé de chauffage rapide RTP dans une atmosphère contenant du soufre.

Une couche 24 de CdS a ensuite été déposée, suivie par une couche 32 de ZnO:Al. Des cellules photovoltaïques avec une surface d'ouverture de 1,4cm² ont été produites par le dépôt d'un grille sur la couche de ZnO :AI. Des modules de 30x30cm ont été fabriqués par interconnexion monolithique.

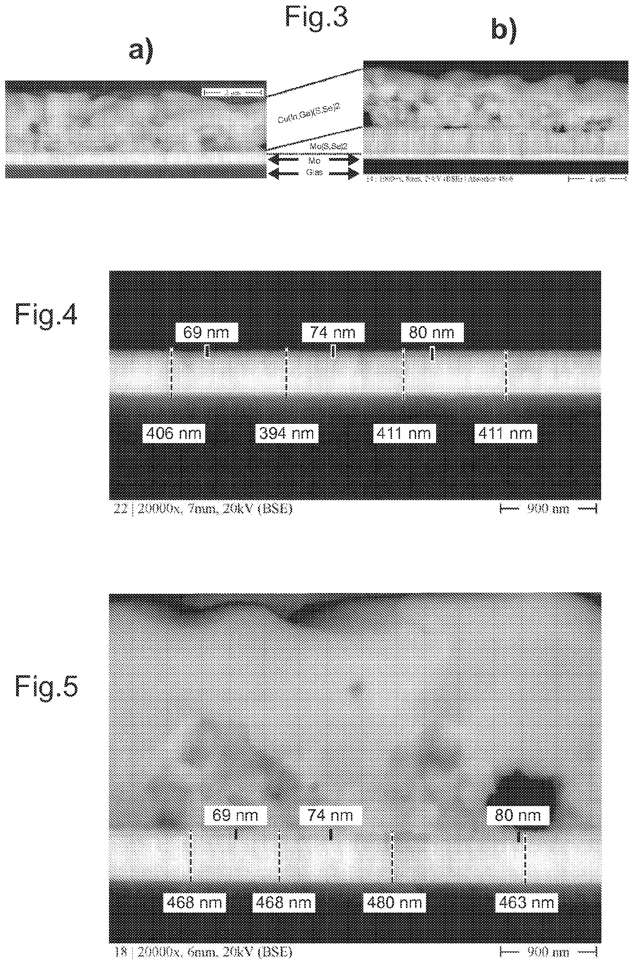

Les figures 3a et 3nb illustrent l'effet de la couche barrière à la sélénisation. Figure 3b : en raison d'une haute température et d'une pression partielle en sélénium élevée, l'épaisseur du composé Mo(S,Se)₂ formé est de plusieurs centaines de nanomètres, laissant seulement une très fine épaisseur de Mo métallique. Figure 3a : la couche barrière à la sélénisation empêche la sélénisation de la couche de molybdène qu'elle protège.

De la même façon, la figure 4 est une image de microscopie électronique montrant un substrat en verre de 3mm, une couche barrière aux alcalins à base en nitrure de silicium, de 130nm, une couche de nitrure de titane de 30nm et une couche de 25nm de molybdène, avant traitement. La figure 5 montre quant à elle le même substrat que sur la figure 4 après dépôt de la couche photoactive et sélénisation. L'épaisseur totale de l'électrode arrière, incluant la couche de Mo(S,Se)₂ et la couche barrière à la sélénisation varie entre 460nm et 480nm, l'épaisseur de la couche de Mo(S,Se)₂ variant quant à elle entre 70nm et 80nm.

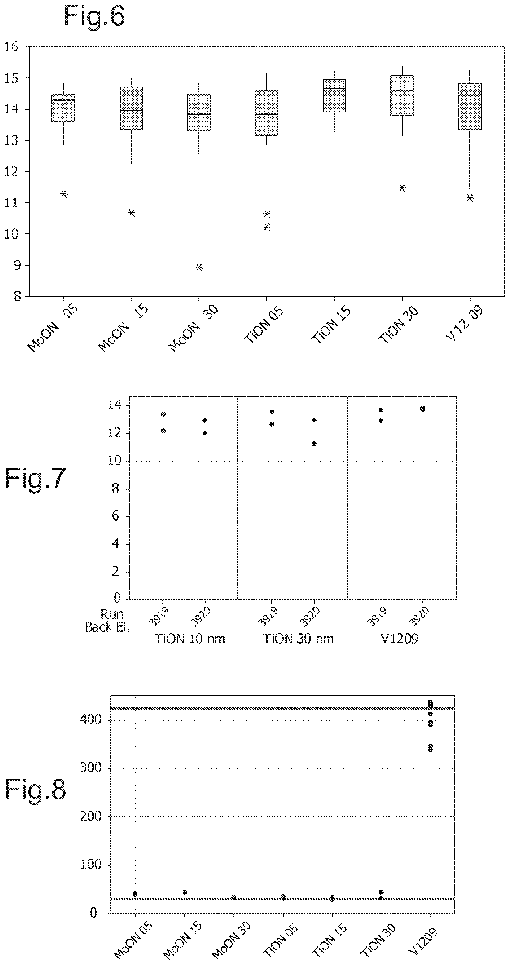

Les figures 6 et 7 illustrent le coefficient de conversion énergétique obtenu en fonction des différents substrats conducteurs utilisés.

La figure 6 présente des résultats d'expérience obtenus pour des cellules photovoltaïques différant entre elles par l'épaisseur de la couche barrière à la sélénisation, en TiON ou MoON (exemples 1 à 6), et comparant ces résultats à une cellule photovoltaïque avec substrat conducteur sans couche barrière à la sélénisation et couche de molybdène épaisse (exemple 7).

Le rendement de la cellule est en ordonnées en %.

Les exemples ne diffèrent que par le revêtement électrode arrière 6 à base de molybdène.
exemple 1 (MoON 05) : verre (3mm) / Si₃N₄ (140nm) / Mo (200nm) / MoON (5nm) / Mo (30nm),
exemple 2 (MoON 15) : verre (3mm) / Si₃N₄ (140nm) / Mo (200nm) / MoON (15nm) / Mo (30nm),
exemple 3 (MoON 30) : verre (3mm) / Si₃N₄ (140nm) / Mo (200nm) / MoON (30nm) / Mo (30nm),
exemple 4 (TiON 05) : verre (3mm) / Si₃N₄ (140nm) / Mo (200nm) / TiON (5nm) / Mo (30nm),
exemple 5 (TiON 15) : verre (3mm) / Si₃N₄ (140nm) / Mo (200nm) / TiON (15nm) / Mo (30nm),
exemple 6 (TiON 30) : verre (3mm) / Si₃N₄ (140nm) / Mo (200nm) / TiON (30nm) / Mo (30nm),
exemple 7 (V1209) : verre (3mm) / Si₃N₄ (140nm) / Mo (425nm)

Les exemples 1 à 6 montrent un avantage à utiliser une couche barrière à base de TiON plutôt qu'une couche barrière à base de MoON.

A noter qu'on entend par TiON ou MoON un oxynitrure avec 0<x<1, x=O/(O+N), O et N étant bien entendu les proportions atomiques.

De meilleurs résultats ont été obtenus avec une épaisseur de 5nm dans le cas du MoON.

Dans le cas du TiON, l'optimum d'épaisseur est d'environ 15nm.

La comparaison des résultats des exemples 1 à 6 avec l'exemple 7 montre en outre qu'il est possible d'obtenir des performances équivalentes avec des revêtements électrode ne combinant que 230nm de Mo, soit 195nm de moins que dans l'exemple 7, soit une économie substantielle de matériau.

La figure 7 illustre le même type de résultats que la figure 4 (i.e. rendement énergétique en %) mais pour des modules complets composés de quarante cellules chacun et utilisant des substrats conducteurs standards verre / Si₃N₄ (140nm) / Mo avec différentes épaisseurs de Mo :
exemple 8 (TiON10) : verre (3mm) / Si₃N₄ (140nm) / Mo (350nm) / TiON (10nm) / Mo (30nm),
exemple 9 (TiON30) : verre (3mm) / Si₃N₄ (140nm) / Mo (350nm) / TiON (30nm) / Mo (30nm),
exemple 10 (V1209) : verre (3mm) / Si₃N₄ (140nm) / Mo (425nm).

Deux rounds d'expérience ont été réalisés (3919 et 3920).

Une épaisseur plus importante de molybdène a été choisie en raison du margeage réalisé pour définir les différentes cellules. Malgré une épaisseur totale de molybdène inférieure de 45nm par rapport au module de référence, les modules présentent des performances qui sont équivalentes.

La figure 8 illustre les résultats de tests de sélénisation de différents revêtements électrodes. L'épaisseur du revêtement électrode sur laquelle le revêtement électrode a été sélénisé est représentée en ordonnées. Pour ces tests, les revêtements électrodes ont été recuits à 520°C dans une atmosphère contenant du sélénium. Les échantillons suivants ont été analysés :
exemple 11 (MoON 05) : verre (3mm) / Si₃N₄ (140nm) / Mo (200nm) / MoON (5nm) / Mo (30nm),
exemple 12 (MoON 15) : verre (3mm) / Si₃N₄ (140nm) / Mo (200nm) / MoON (15nm) / Mo (30nm),
exemple 13 (MoON 30) : verre (3mm) / Si₃N₄ (140nm) / Mo (200nm) / MoON (30nm) / Mo (30nm),
exemple 14 (TiON 05) : verre (3mm) / Si₃N₄ (140nm) / Mo (200nm) / TiON (5nm) / Mo (30nm),
exemple 15 (TiON 15) : verre (3mm) / Si₃N₄ (140nm) / Mo (200nm) / TiON (15nm) / Mo (30nm),
exemple 16 (TiON 30) : verre (3mm) / Si₃N₄ (140nm) / Mo (200nm) / TiON (30nm) / Mo (30nm),
exemple 17 (V1209) : verre (3mm) / Si₃N₄ (140nm) / Mo (425nm)

Comme l'illustre la figure 8, une couche barrière à la sélénisation, même de 5nm, que le matériau soit TiON ou MoON, a un effet de protection contre la sélénisation de la couche principale 8 à base de molybdène. Dans tous les exemples, la couche supérieure 12 à base de molybdène a été complètement transformée en MoSe₂.

## Revendications

1. Substrat conducteur (1) pour cellule photovoltaïque, comprenant un substrat porteur (2) et un revêtement électrode (6) formé sur le substrat porteur (2), dans lequel le revêtement électrode (6) comprend :
- une couche principale (8) à base de molybdène formée sur le substrat porteur (2) ;
- une couche barrière à la sélénisation (10) formée sur la couche principale (8) à base de molybdène, la couche barrière à la sélénisation (10) ayant une épaisseur inférieure à 50nm, de préférence inférieure ou égale à 30nm, de préférence encore inférieure ou égale à 20nm ; et
- sur la couche barrière à la sélénisation (10), une couche supérieure (12) à base d'un métal M propre à former, après sulfuration et/ou sélénisation, une couche de contact ohmique avec un matériau semi-conducteur photoactif.

2. Substrat conducteur (1) selon la revendication 1, dans lequel la couche barrière à la sélénisation (10) est à base d'un nitrure ou d'un oxynitrure métallique avec le métal M choisi parmi le titane, le molybdène, le zirconium ou le tantale et une teneur en oxygène x=O/(O+N) avec x= 0 ou 0<x<1.

3. Substrat conducteur (1) selon la revendication 2, dans lequel la couche barrière à la sélénisation (10) est à base d'un oxynitrure métallique avec le métal M choisi parmi le titane, le molybdène, le zirconium ou le tantale et une teneur en oxygène x=O/(O+N) avec 0<x<1, par exemple 0,05<x<0,95, par exemple 0,1<x<0,9.

4. Substrat conducteur (1) selon la revendication 1, dans lequel la couche barrière à la sélénisation (10) est un composé à base de molybdène avec une teneur élevée en oxygène et/ou en azote.

5. Substrat conducteur (1) selon la revendication 4, dans lequel la couche barrière à la sélénisation (10) a une résistivité comprise entre 20µOhm.cm et 50µOhm.cm.

6. Substrat conducteur (1) selon l'une quelconque des revendications précédentes, dans lequel ledit métal M est propre à former un composé de type sulfure et/ou séléniure semi-conducteur de type p avec une concentration de porteurs de charge supérieure ou égale à 10¹⁶/cm³ et un travail de sortie supérieur ou égal à 4,5eV.

7. Substrat conducteur (1) selon la revendication précédente, dans lequel ladite couche supérieure à base d'un métal M est à base de molybdène et/ou de tungstène.

8. Dispositif semi-conducteur (20) comprenant un substrat porteur (2) et un revêtement électrode (6') formé sur le substrat porteur (2), le revêtement électrode (6') comprenant :
- une couche principale (8) à base de molybdène ;
- une couche barrière à la sélénisation (10) formée sur la couche principale (8) à base de molybdène, la couche barrière à sélénisation (10) ayant une épaisseur inférieure à 50 nm;
- une couche photoactive (22) en un matériau semi-conducteur photoactif à base de chalcopyrite de cuivre et de sélénium et/ou de soufre, par exemple un matériau de type Cu(In,Ga)(S,Se)₂, notamment CIS ou CIGS, ou encore un matériau de type Cu₂(Zn,Sn)(S,Se)₄, la couche photoactive (22) étant formée sur la couche barrière à la sélénisation (10) ; et
- entre la couche barrière à la sélénisation (10) et la couche photoactive (22), une couche de contact ohmique (12') à base d'un composé de type sulfure et/ou séléniure d'un métal M.

9. Dispositif semi-conducteur (20) selon la revendication précédente, dans lequel le matériau de la couche de contact ohmique (12') est un matériau semi-conducteur de type p avec une concentration de porteurs de charge supérieure ou égale à 10¹⁶/cm³ et un travail de sortie supérieur ou égal à 4,5eV.

10. Dispositif semi-conducteur (20) selon la revendication précédente, dans lequel la couche de contact ohmique (12') est à base d'un composé de type sulfure et/ou séléniure de molybdène et/ou de tungstène.

11. Cellule photovoltaïque (30) comprenant un dispositif semi-conducteur (20) selon l'une quelconque des revendications 8 à 10, et un revêtement électrode transparent (32) formé sur la couche photoactive (22).

12. Procédé de fabrication d'un substrat conducteur (1) pour cellule photovoltaïque (30), comprenant des étapes consistant à :
- déposer une couche principale (8) à base de molybdène sur un substrat porteur (2);
- déposer une couche barrière à la sélénisation (10) sur la couche principale (8) à base de molybdène, la couche barrière à la sélénisation ayant une épaisseur inférieure à 50 nm;
- déposer, sur la couche barrière à la sélénisation (10), une couche supérieure (12) à base d'un métal M propre à former, après sulfuration et/ou sélénisation, une couche de contact ohmique avec un matériau semi-conducteur photoactif ; et
- transformer la couche supérieure (12) à base de métal M en un sulfure et/ou séléniure du métal M.

13. Procédé de fabrication selon la revendication 12, comprenant une étape de formation d'une couche photoactive (22) par sélénisation et/ou sulfuration, sur ladite couche supérieure (12) à base d'un métal M, l'étape de transformation de ladite couche supérieure à base d'un métal M (12) étant réalisée avant ou pendant la formation de ladite couche photoactive (22), de préférence pendant.

14. Procédé de fabrication selon la revendication 12 ou 13, dans lequel, après sulfuration et/ou sélénisation, ladite couche supérieure (12) est à base d'un semi-conducteur de type p avec une concentration de porteurs de charge supérieure ou égale à 10¹⁶/cm³ et un travail de sortie supérieur ou égal à 4,5eV.

15. Procédé de fabrication selon l'une quelconque des revendications 12 à 14, dans lequel l'étape de formation de la couche photoactive (22) comprenant une étape de sélénisation et/ou sulfuration à une température supérieure ou égale à 300°C.

## Patentansprüche

1. Leitendes Substrat (1) für eine Photovoltaikzelle, das ein Trägersubstrat (2) und eine auf dem Trägersubstrat (2) geformte Elektrodenbeschichtung (6) enthält, wobei die Elektrodenbeschichtung (6) enthält:
- eine auf dem Trägersubstrat (2) geformte Hauptschicht (8) auf Molybdänbasis;
- eine auf der Hauptschicht (8) auf Molybdänbasis geformte Selenisierungs-Sperrschicht (10), wobei die Selenisierungs-Sperrschicht (10) eine Dicke von weniger als 50nm, vorzugsweise weniger als oder gleich 30nm, weiter bevorzugt weniger als oder gleich 20nm hat; und
- auf der Selenisierungs-Sperrschicht (10) eine Oberschicht (12) auf der Basis eines Metalls M, die nach Sulfidierung und/oder Selenisierung eine Ohmsche Kontaktschicht mit einem photoaktiven Halbleitermaterial formen kann.

2. Leitendes Substrat (1) nach Anspruch 1, wobei die Selenisierungs-Sperrschicht (10) auf der Basis eines Nitrids oder eines metallischen Oxynitrids ist, wobei das Metall M aus Titan, Molybdän, Zirkonium oder Tantal und einem Sauerstoffgehalt x=O/(O+N) mit x=0 oder 0<x<1 ausgewählt wird.

3. Leitendes Substrat (1) nach Anspruch 2, wobei la Selenisierungs-Sperrschicht (10) auf der Basis eines metallischen Oxynitrids ist, wobei das Metall M aus Titan, Molybdän, Zirkonium oder Tantal und einem Sauerstoffgehalt x=O/{O+N) mit 0<x<1, zum Beispiel 0,05<x<0,95, zum Beispiel 0,1<x<0,9 ausgewählt wird.

4. Leitendes Substrat (1) nach Anspruch 1, wobei die Selenisierungs-Sperrschicht (10) eine Verbindung auf Molybdänbasis mit einem hohen Gehalt an Sauerstoff und/oder Stickstoff ist.

5. Leitendes Substrat (1) nach Anspruch 4, wobei die Selenisierungs-Sperrschicht (10) einen spezifischen Widerstand zwischen 20µOhm.cm und 50µOhm.cm hat.

6. Leitendes Substrat (1) nach einem der vorhergehenden Ansprüche, wobei das Metall M eine Verbindung eines p-Typ-Halbleiterverbindung vom Typ Sulfid und/oder Selenid mit einer Konzentration von Ladungsträgern höher als oder gleich 10¹⁶/cm³ und einer Austrittsarbeit höher als oder gleich 4,5eV formen kann.

7. Leitendes Substrat (1) nach dem vorhergehenden Anspruch, wobei die Oberschicht auf der Basis eines Metalls M auf Molybdän- und/oder Wolframbasis ist.

8. Halbleitervorrichtung (20), die ein Trägersubstrat (2) und eine auf dem Trägersubstrat (2) geformte Elektrodenbeschichtung (6') enthält, wobei die Elektrodenbeschichtung (6') enthält:
- eine Hauptschicht (8) auf Molybdänbasis;
- eine auf der Hauptschicht (8) auf Molybdänbasis geformte Selenisierungs-Sperrschicht (10), wobei die Selenisierungs-Sperrschicht (10) eine Dicke von weniger als 50nm hat;
- eine photoaktive Schicht (22) aus einem photoaktiven Halbleitermaterial auf der Basis von Kupfer-Chalkopyrit und Selen und/oder Schwefel, zum Beispiel ein Material der Art insbesondere CIS oder CIGS, oder auch aus einem Material der Art CU₂(Zn,Sn)(S,Se)₄, wobei die photoaktive Schicht (22) auf der Selenisierungs-Sperrschicht (10) geformt ist; und
- zwischen der Selenisierungs-Sperrschicht (10) und der photoaktiven Schicht (22) eine Ohmsche Kontaktschicht (12') auf der Basis einer Verbindung der Art Sulfid und/oder Selenid eines Metalls M.

9. Halbleitervorrichtung (20) nach dem vorhergehenden Anspruch, wobei das Material der Ohmschen Kontaktschicht (12') ein p-Typ-Halbleitermaterial mit einer Konzentration an Ladungsträgern höher als oder gleich 10¹⁶/cm³ und einer Austrittsarbeit höher als oder gleich 4,5eV ist.

10. Halbleitervorrichtung (20) nach dem vorhergehenden Anspruch, wobei die Ohmsche Kontaktschicht (12') auf der Basis einer Verbindung der Art Molybdän- und/oder Wolframsulfid und/oder -selenid ist.

11. Photovoltaikzelle (30), die eine Halbleitervorrichtung (20) nach einem der Ansprüche 8 bis 10 und eine durchsichtige Elektrodenbeschichtung (32) enthält, die auf der photoaktiven Schicht (22) gebildet wird.

12. Herstellungsverfahren eines leitenden Substrats (1) für eine Photovoltaikzelle (30), das Schritte enthält, die darin bestehen:
- eine Hauptschicht (8) auf Molybdänbasis auf ein Trägersubstrat (2) aufzubringen;
- eine Selenisierungs-Sperrschicht (10) auf die Hauptschicht (8) auf Molybdänbasis aufzubringen, wobei die Selenisierungs-Sperrschicht eine Dicke von weniger als 50nm hat;
- auf die Selenisierungs-Sperrschicht (10) eine Oberschicht (12) auf der Basis eines Metalls M aufzubringen, die nach Sulfidierung und/oder Selenisierung eine Ohmsche Kontaktschicht mit einem photoaktiven Halbleitermaterial formen kann; und
- die Oberschicht (12) auf der Basis eines Metalls M in ein Sulfid und/oder oder Selenid des Metalls M umzuwandeln.

13. Herstellungsverfahren nach Anspruch 12, das einen Schritt des Formens einer photoaktiven Schicht (22) durch Selenisierung und/oder Sulfidierung auf der Oberschicht (12) auf der Basis eines Metalls M enthält, wobei der Umwandlungsschritt der Oberschicht auf der Basis eines Metalls M (12) vor oder während des Formens der photoaktiven Schicht (22), vorzugsweise während dessen, erfolgt.

14. Herstellungsverfahren nach Anspruch 12 oder 13, wobei nach Sulfidierung und/oder Selenisierung die Oberschicht (12) auf der Basis eines p-Typ-Halbleiters mit einer Konzentration an Ladungsträgern höher als oder gleich 10¹⁶/cm³ und einer Austrittsarbeit höher als oder gleich 4,5eV ist.

15. Herstellungsverfahren nach einem der Ansprüche 12 bis 14, wobei der Schritt des Formens der photoaktiven Schicht (22) einen Schritt der Selenisierung und/oder Sulfidierung bei einer Temperatur von mehr als oder gleich 300°C enthält.

## Claims

1. Conducting substrate (1) for a photovoltaic cell, comprising a carrier substrate (2) and an electrode coating (6) formed on the carrier substrate (2), wherein the electrode coating (6) comprises:
- a main molybdenum-based layer (8) formed on the carrier substrate (2);
- a barrier layer to selenization (10) formed on the main molybdenum-based layer (8), the barrier layer to selenization (10) having a thickness of less than 50 nm, preferably of less than or equal to 30 nm, more preferably of less than or equal to 20 nm; and
- on the barrier layer to selenization (10), an upper layer (12) based on a metal M capable of forming, after sulfurization and/or selenization, an ohmic contact layer with a photoactive semiconducting material.

2. Conducting substrate (1) according to Claim 1, wherein the barrier layer to selenization (10) is based on a metal nitride or oxynitride with the metal M chosen from titanium, molybdenum, zirconium or tantalum and an oxygen content x = O/(O+N) with x = 0 or 0<x<1.

3. Conducting substrate (1) according to Claim 2, wherein the barrier layer to selenization (10) is based on a metal oxynitride with the metal M chosen from titanium, molybdenum, zirconium or tantalum and an oxygen content x = O/(O+N) with 0<x<1, for example 0.05<x<0.95, for example 0.1<x<0.9.

4. Conducting substrate (1) according to Claim 1, wherein the barrier layer to selenization (10) is a molybdenum-based compound with a high content of oxygen and/or nitrogen.

5. Conducting substrate (1) according to Claim 4, wherein the barrier layer to selenization (10) has a resistivity of between 20 µohm.cm and 50 µohm.cm.

6. Conducting substrate (1) according to any one of the preceding claims, wherein the said metal M is capable of forming a compound of semiconducting sulfide and/or selenide type of p type with a concentration of charge carriers of greater than or equal to 10¹⁶/cm³ and a work function of greater than or equal to 4.5 eV.

7. Conducting substrate (1) according to the preceding claim, wherein the said upper layer based on a metal M is molybdenum-based and/or tungsten-based.

8. Semiconducting device (20) comprising a carrier substrate (2) and an electrode coating (6') formed on the carrier substrate (2), the electrode coating (6') comprising:
- a main molybdenum-based layer (8);
- a barrier layer to selenization (10) formed on the main molybdenum-based layer (8), the barrier layer to selenization (10) having a thickness of less than 50 nm;
- a photoactive layer (22) made of a photoactive semiconducting material based on copper and selenium and/or sulfur chalcopyrite, for example a material of Cu(In,Ga)(S,Se)₂ type, in particular CIS or CIGS, or also a material of Cu₂(Zn,Sn)(S,Se)₄ type, the photoactive layer (22) being formed on the barrier layer to selenization (10); and
- between the barrier layer to selenization (10) and the photoactive layer (22), an ohmic contact layer (12') based on a compound of the type consisting of sulfide and/or selenide of a metal M.

9. Semiconducting device (20) according to the preceding claim, wherein the material of the ohmic contact layer (12') is a semiconducting material of p type with a concentration of charge carriers of greater than or equal to 10¹⁶/cm³ and a work function of greater than or equal to 4.5 eV.

10. Semiconducting device (20) according to the preceding claim, wherein the ohmic contact layer (12') is based on a compound of molybdenum and/or tungsten sulfide and/or selenide type.

11. Photovoltaic cell (30) comprising a semiconducting device (20) according to any one of Claims 8 to 10 and a transparent electrode coating (32) formed on the photoactive layer (22).

12. Process for the manufacture of a conducting substrate (1) for a photovoltaic cell (30), comprising stages consisting in:
- depositing a main molybdenum-based layer (8) on a carrier substrate (2);
- depositing a barrier layer to selenization (10) on the main molybdenum-based layer (8), the barrier layer to selenization (10) having a thickness of less than 50 nm;
- depositing, on the barrier layer to selenization (10), an upper layer (12) based on a metal M capable of forming, after sulfurization and/or selenization, an ohmic contact layer with a photoactive semiconducting material; and
- transforming the upper layer (12) based on a metal M into a sulfide and/or selenide of the metal M.

13. Manufacturing process according to Claim 12, comprising a stage of formation of a photoactive layer (22), by selenization and/or sulfurization, on the said upper layer (12) based on a metal M, the stage of transformation of the said upper layer (12) based on a metal M being carried out before or during the formation of the said photoactive layer (22), preferably during.

14. Manufacturing process according to Claim 12 or 13, wherein, after sulfurization and/or selenization, the said upper layer (12) is based on a semiconductor of p type with a concentration of charge carriers of greater than or equal to 10¹⁶/cm³ and a work function of greater than or equal to 4.5 eV.

15. Manufacturing process according to any one of Claims 12 to 14, wherein the stage of formation of the photoactive layer (22) comprising a stage of selenization and/or sulfurization at a temperature of greater than or equal to 300°C.
